# EUROPEAN PATENT SPECIFICATION

(11) **EP 4 084 053 B1**
(45) Date of publication and mention of the grant of the patent: **31.01.2024**
(21) Application number: 21863069.7
(22) Date of filing: 04.08.2021
(51) Int. Cl.: H01L 21/768, H01L 23/522, H01L 23/48

(54) **SEMICONDUCTOR STRUCTURE AND ITS METHOD FOR MANUFACTURING**
HALBLEITERSTRUKTUR UND VERFAHREN ZU IHRER HERSTELLUNG
STRUCTURE SEMI-CONDUCTRICE ET SON PROCÉDÉ DE FABRICATION

(30) Priority: 10.03.2021 CN 202110259350
(43) Date of publication of application: 02.11.2022
(73) Proprietor: Changxin Memory Technologies, Inc., Hefei City, Anhui 230601 (CN)
(72) Inventor: CHANG, Chih-wei, Anhui 230601 (CN)
(74) Representative: V.O.
(86) International application number: PCT/CN2021/110605
(87) International publication number: WO 2022/188346

(56) References cited:
- CN-A- 102 651 355
- CN-A- 104 011 848
- CN-A- 108 933 101
- JP-A- 2019 029 468
- US-A1- 2008 067 689
- US-A1- 2013 127 019
- US-A1- 2015 243 583
- US-A1- 2018 061 740

## Description

### CROSS-REFERENCE TO RELATED APPLICATIONS

The present application is based upon and claims priority to Chinese patent application No. 202110259350.X filed on March 10, 2021 and entitled "Semiconductor Structure and Method for Manufacturing Semiconductor Structure".

### TECHNICAL FIELD

This disclosure relates to the field of semiconductor technology, and more particularly, to a semiconductor structure and a method for manufacturing the semiconductor structure.

### BACKGROUND

In the related art, the metal conductive material filled in the via will affect the surrounding lattice of the via portion during the thermal expansion process, or directly cause the deformation of the upper metal layer, thereby affecting the performance of the semiconductor structure.

Related technologies can be found from US2008067689A1.

### SUMMARY

The invention is defined in the independent claims, and the preferable features according to the present application are defined in the dependent claims.

The disclosure provides a semiconductor structure and a method for manufacturing the semiconductor structure, so as to improve the performance of the semiconductor structure.

The semiconductor structure of the disclosure includes the base and the conductive portion that includes the via portion and the first conductive layer. By arranging the air gap in the base and exposing the air gap to the conductive portion in the base, a part of the conductive material of the conductive portion can enter the air gap during the thermal expansion of the conductive material in the via portion, so as to avoid squeezing the surrounding lattice of the via portion.

### BRIEF DESCRIPTION OF THE DRAWINGS

By considering the following detailed description of the preferred embodiments of the disclosure in combination with the accompanying drawings, various objectives, features, and advantages of the disclosure will become more apparent. The drawings are not necessarily drawn to scale but merely exemplary illustrations of the disclosure. In the drawings, the same reference numerals always refer to the same or similar component.
FIG. 1 illustrates a schematic structural diagram of a semiconductor structure according to an exemplary embodiment the disclosure.
FIG. 2 illustrates a schematic structural diagram of a semiconductor structure after expansion according to an exemplary embodiment of the disclosure.
FIG. 3 illustrates a schematic structural diagram of a conductive portion of a semiconductor structure according to an exemplary embodiment of the disclosure.
FIG. 4 illustrates a flowchart of a method for manufacturing a semiconductor structure according to an exemplary embodiment of the disclosure.
FIG. 5 illustrates a schematic structural diagram of a process for forming a via portion according to the method for manufacturing the semiconductor structure shown in an exemplary embodiment of the disclosure.
FIG. 6 illustrates a schematic structural diagram of a process for forming a first insulating layer according to the method for manufacturing the semiconductor structure shown in an exemplary embodiment of the disclosure.
FIG. 7 illustrates a schematic structural diagram of a process for forming a groove according to the method for manufacturing the semiconductor structure shown in an exemplary embodiment of the disclosure.
FIG. 8 illustrates a schematic structural diagram of a process for forming a first conductive layer according to the method for manufacturing the semiconductor structure shown in an exemplary embodiment of the disclosure.
FIG. 9 illustrates a schematic structural diagram of a process for forming a second insulating layer according to the method for manufacturing the semiconductor structure shown in an exemplary embodiment of the disclosure.
FIG. 10 illustrates a schematic structural diagram of a process for forming an opening according to the method for manufacturing the semiconductor structure shown in an exemplary embodiment of the disclosure.
FIG. 11 illustrates a schematic structural diagram of a process for forming an insulating covering layer according to the method for manufacturing the semiconductor structure shown in an exemplary embodiment of the disclosure.
FIG. 12 illustrates a schematic structural diagram of a process for thinning the insulating covering layer according to the method for manufacturing the semiconductor structure shown in an exemplary embodiment of the disclosure.

The reference numerals are explained as follows:
10: base; 11: air gap; 12: silicon substrate; 13: insulating layer; 20: conductive portion; 21: via portion; 22: first conductive layer; 221: via; 30: second conductive layer; 31: connecting column;
14: opening; 15: first insulating layer; 16: groove; 17: bottom insulating layer; 18: sidewall insulating layer; 19: second insulating layer; 151: insulating covering layer.

### DETAILED DESCRIPTION

Typical embodiments embodying the features and advantages of the disclosure will be described in detail in the following description. It should be understood that the description and figures therein are essentially for illustrative purposes, rather than limiting the disclosure.

In the following description of different exemplary embodiments of the disclosure, reference may be made to the figures, which form a part of the disclosure. And different exemplary structures, systems, and steps that can implement various aspects of the disclosure may be shown by the way of example. Moreover, although the terms of "above", "between", "within", etc. may be used in the specification to describe different exemplary features and elements of the disclosure, these terms are used herein for convenience only, for example, according to the directions of the examples in the figures. Nothing in the specification should be understood as requiring a specific three-dimensional direction of the structure to fall within the scope of the disclosure.

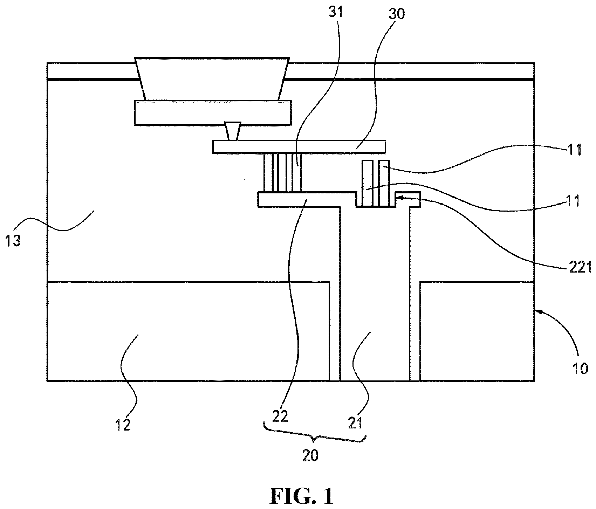

An embodiment of the disclosure provides a semiconductor structure. Referring to FIG. 1, the semiconductor structure includes a base 10 and a conductive portion 20 arranged in the base 10, where the conductive portion 20 includes a via portion 21 and a first conductive layer 22. The first conductive layer 22 is connected with the via portion 21 and arranged above the via portion 21. An air gap 11 is arranged in the base 10, and one end of the air gap is configured to expose the conductive portion 20.

The semiconductor structure of the disclosure includes the base 10 and the conductive portion 20 that includes the via portion 21 and the first conductive layer 22. By arranging the air gap 11 in the base 10 and exposing the air gap 11 to the conductive portion 20 in the base 10, a part of the conductive material of the conductive portion 20 may enter the air gap 11 during the thermal expansion of the conductive material in the via portion 21, so as to avoid squeezing the surrounding lattice of the via portion 21.

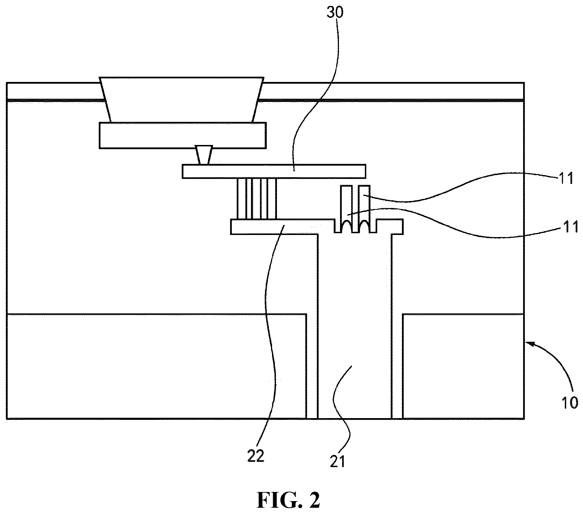

Specifically, as shown in FIG. 1, in a normal state of the conductive portion 20, there may be no conductive material of the conductive portion 20 in the air gap 11, but when the conductive material of the via portion 21 and the conductive material of the first conductive layer 22 may be thermally expanded. As shown in FIG. 2, part of the conductive material will enter the air gap 11, so as to prevent the conductive portion 20 from squeezing the surrounding lattice of the via portion 21 or other adjacent conductive layers after the thermal expansion.

In an embodiment, the via portion 21 may include copper (Cu), tungsten (W) and other conductive materials related to an integrated circuit. The via portion 21 may be interpreted as a via formed in the base 10 where the conductive material is filled in the via. In the embodiment, the via may be filled with copper.

In some embodiments, the via portion 21 may be a silicon via.

In the disclosure, one end of the air gap 11 is configured to expose a top end of the via portion 21. That is, after the via portion 21 being thermally expanded, the conductive material of the via portion 21 directly enters the air gap 11, thereby preventing the conductive material from squeezing the surrounding lattice of the via portion 21 or other adjacent conductive layers.

It should be noted that the air gap 11 includes a first end and a second end. Both of the first end and the second end of the air gap 11 are arranged in the base 10, a cavity may be formed in the air gap 11, and the top end of the via 21 is directly connected with the first end or the second end of the air gap 11. Therefore, after the via portion 21 being thermally expanded, part of the conductive material of the via portion 21 directly enters the air gap 11, thereby preventing conductive material from squeezing the surrounding lattice of the via portion 21 or other adjacent conductive layers.

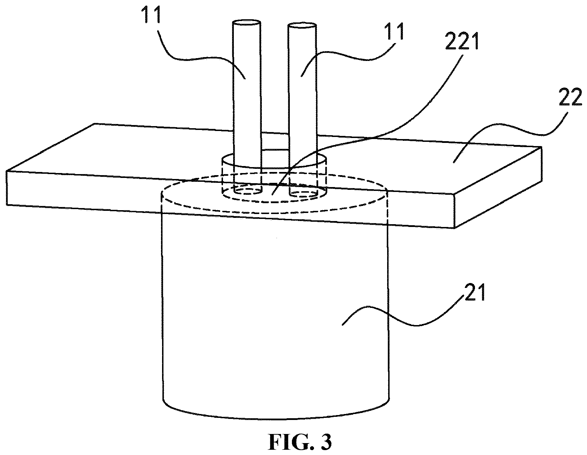

In the disclosure, as shown in FIGS. 1 and 3, a via 221 is arranged in the first conductive layer 22, to expose the top end of the via portion 21, and at least part of the air gap 11 is arranged in the via 221.

Specifically, the via 221 may be formed inside of the first conductive layer 22, and part of the via 221 may be filled, and the other unfilled space may form at least part of the air gap 11. This arrangement can allow one end of the air gap 11 to expose the top end of the via 21, so as to ensure that part of the conductive materials of the via portion 21 can directly enter the air gap 11 after the via 21 being thermally expanded. Moreover, the filled part in the via 221 may not be the conductive material, so the arrangement of the via 221 can protect the first conductive layer 22 and also prevent other problems caused by the deformation (e.g., a fracture) of the first conductive layer 22. Due to the existence of the via 221, the thermal expansion of the first conductive layer 22 will also be released, so as to further protect the first conductive layer 22.

In some embodiments, a height of the air gap 11 may be equal to a height of the via 221; that is, the height of the air gap 11 may be equal to a thickness of the first conductive layer 22.

In some embodiments, the height of the air gap 11 may be greater than the height of the via 221; that is, the height of the air gap 11 may be greater than the thickness of the first conductive layer 22, so that the height of the air gap 11 will be high enough to form sufficient reserved space, to ensure that the conductive material of the via portion 21 can have sufficient expansion space after the thermal expansion of the via portion 21.

In some embodiments, the via 221 may be an edge cut, that is, it can be understood as a cutting part of the material at the edge of the first conductive layer 22, thereby forming an opening that can expose the top end of the via portion 21. Therefore, after the air gap 11 being formed, the top end of the via portion 21 may be exposed by the air gap 11.

In some embodiments, the via 221 may be arranged in a middle of the first conductive layer 22; that is, the via 221 may be an internal via with a circumferentially closed sidewall formed by the first conductive layer 22, which can be regarded as digging a via inside of the first conductive layer 22 to expose the top end of the via portion 21. Therefore, after the air gap 11 being formed, the top end of the via portion 21 is exposed by the air gap 11.

It should be noted that the middle of the first conductive layer 22 may refer to a location other than the circumferential sidewall of the first conductive layer 22, which means that the via 221 does not intersect the circumferential sidewall of the first conductive layer 22.

It should be noted that the specific shape of the via 221 will not be limited, and it may be a polygonal hole, a circular hole, or a special-shaped hole, etc.

Correspondingly, the specific shape of the air gap 11 will not be limited, and it may be a polygonal hole, a circular hole, or a special-shaped hole, etc.

In one embodiment, an area of a cross section of the via 221 may be smaller than an area of a cross section of the via portion 21, so as to ensure that the first conductive layer 22 can be reliably connected with the via portion 21, and further to ensure that there will be a space for forming the air gap 11.

In one embodiment, the height of the air gap 11 may be greater than the thickness of the first conductive layer 22, so as to ensure that the air gap 11 may have enough space. Therefore, after the via portion 21 being thermally expanded, part of the conductive material of the via portion 21 can enter into the air gap 11.

In one embodiment, as shown in FIG. 1, the semiconductor structure may further include a second conductive layer 30 which is arranged in the base 10. The second conductive layer 30 may be spaced apart from the first conductive layer 22, and arranged above the first conductive layer 22. The air gap 11 may be arranged under the second conductive layer 30 and spaced apart from the second conductive layer 30. Therefore, after the conductive material entering the air gap 11, the second conductive layer 30 may not be connected with the conductive material in the air gap 11.

As shown in FIGS. 1 and 2, the first conductive layer 22 may be connected with the second conductive layer 30 through a connecting column 31 (i.e., a conductive structure), and the air gap 11 may be directly arranged under the second conductive layer 30. In this case, it will be necessary to ensure that the air gap 11 can be spaced apart from the second conductive layer 30; that is, the top end of the air gap 11 may not expose the second conductive layer 30.

In the disclosure, the first conductive layer 22 includes a plurality of sub-conductive layers that are spaced apart from each other, and two adjacent sub-conductive layers from the plurality of sub-conductive layers are configured to expose the top end of the via portion 21. At least part of the air gap 11 is arranged between the two adjacent sub-conductive layers.

Compared with the via 221 arranged in the first conductive layer 22, this structure may form an exposed space through the plurality of sub-conductive layers that are spaced apart from each other. Therefore, the air gap 11 can be formed between two adjacent sub-conductive layers. For example, a plurality of sub-conductive layers parallel to each other can be provided, and at least part of the plurality of sub-conductive layers may be connected with the via portion 21. The plurality of sub-conductive layers may be all electrically connected. For example, the conductive layer may be arranged on the plurality of sub-conductive layers for electrical connection, or it may be connected with the second conductive layer 30 through the connecting column 31. That is, the electrical connection of the plurality of sub-conductive layers can also be realized. The electrical connection manner of the plurality of sub-conductive layers will not be limited here.

In one embodiment of the present disclosure not covered by the claimed invention, one end of the air gap 11 may be configured to expose the top end of the first conductive layer 22, where the air gap 11 may be arranged directly above the via portion 21. In this way, even if one end of the air gap 11 is not directly connected with the via portion 21, since the via portion 21 and the air gap 11 are directly opposed to each other, even if via portion 21 is thermally expanded to squeeze the first conductive layer 22 between the via portion 21 and the air gap 11, the conductive material can be allowed to enter the air gap 11, thereby preventing the conductive material from squeezing the surrounding lattice of the via portion 21 or other adjacent conductive layers.

In one embodiment, the air gap 11 may include a plurality of air gaps arranged at an interval, and each of the plurality of air gaps may be configured to expose the conductive portion, so that the conductive material can have sufficient expansion space.

In one embodiment, as shown in FIGS. 1 and 2, the base 10 may include a silicon substrate 12, where a top end of the silicon substrate 12 may be higher than an upper surface of the silicon substrate 12. And the base 10 may further include an insulating layer 13, which may be configured to cover the upper surface of the silicon substrate 12 and cover an outer surface of the via portion 21. Both of the first conductive layer 22 and the air gap 11 may be arranged in the insulating layer 13.

Specifically, the silicon substrate 12 may be formed of a silicon-containing material. The silicon substrate 12 may be formed of any suitable material, for example, including at least one of silicon, single crystal silicon, amorphous silicon, silicon germanium, single crystal silicon germanium, silicon carbide, and sapphire.

The insulating layer 13 may include silicon dioxide (SiO2), silicon oxycarbide (SiOC), silicon nitride (SiN), silicon carbonitride (SiCN) and other insulating materials related to the integrated circuit. The insulating layer 13 may fill part of the via 221.

It should be noted that the silicon substrate 12 and the insulating layer 13 may also be provided with other conductive structures, which will not be limited herein, and can be selected according to the requirements in the related art.

The semiconductor structure of the disclosure may relate to a wafer process technology, in particular to a via portion manufacturing technology. In most of the via portion manufacturing technologies, copper metal will be filled in the via portion as the conductive material. However, excessive thermal expansion of copper will affect the surrounding lattice of the via portion or the deformation of the upper metal layer, which can lead to a reduction of the yield or the reliability of the chip in serious cases. Therefore, in related art, the upper metal layer usually does not arrange effective circuits, which wastes the chip design space and also affects the size of the chip. The semiconductor structure of the disclosure uses the air gap to prevent metal protrusions during copper thermal expansion, that is, the air gap 11 can be used as a buffer space during copper expansion to reduce the impact of metal thermal expansion on the upper circuit. In this way, the upper space of the via portion can be used for circuit design, and thus, the size of the chip design can be reduced.

In some embodiments, the via 221 may be a circular hole, the diameter of the via 221 may be between 1 µm and 10 µm, and the diameter of the via 221 may not be greater than the diameter of the via portion 21. In some embodiments, the diameter of the via 221 may be equal to half of the diameter of the via portion 21.

In some embodiments, the air gap 11 may be a circular hole, the diameter of the air gap 11 may be between 20 nm and 200 nm, and the height may be between 50 nm and 200 nm, and there may be one or more air gaps 11.

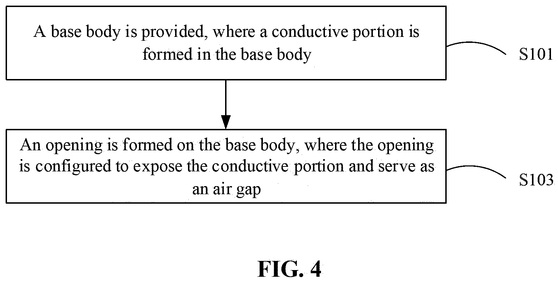

An embodiment of the disclosure further provides a method for manufacturing a semiconductor structure. Referring to FIG. 4, the method for manufacturing the semiconductor structure includes the following operations of S101 and S103.

In the operation of S101, a base body is set, where a conductive portion 20 is formed in the base body, and the conductive portion 20 includes a via portion 21 and a first conductive layer 22. The first conductive layer 22 may be connected with the via portion 21 and arranged above the via portion 21.

In the operation of S103, an opening 14 is formed on the base body, where the opening is configured to expose the conductive portion 20 and serve as an air gap 11.

In the method for manufacturing the semiconductor structure according to one embodiment of the disclosure, by forming the air gap 11 in the base body, the air gap 11 may be configured to expose the conductive portion 20 arranged in the base body. Therefore, part of the conductive material of the conductive portion 20 can enter the air gap 11 during the thermal expansion of the conductive material of the via portion 21, so as to avoid squeezing the surrounding lattice of the via portion 21.

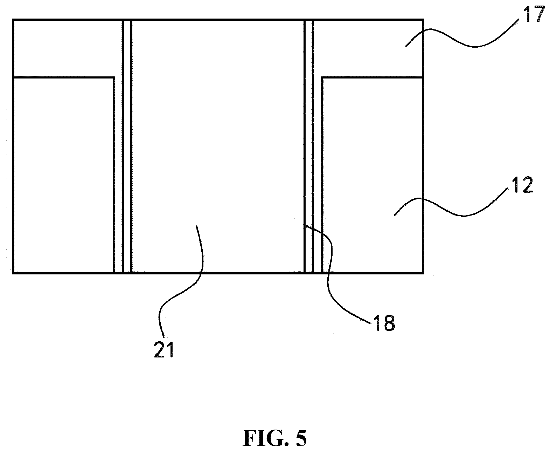

In some embodiments, as shown in FIG. 5, the base body may include a silicon substrate 12, a bottom insulating layer 17, and a sidewall insulating layer 18. The bottom insulating layer 17 may be formed on the upper surface of the silicon substrate 12 and the inside of the silicon substrate 12. And the sidewall insulating layer 18 may be formed inside of the bottom insulation layer 17 and may cover the sidewall of the via portion 21.

It should be noted that the bottom insulating layer 17 and the sidewall insulating layer 18 may include silicon dioxide (SiO2), silicon oxycarbide (SiOC), silicon nitride (SiN), silicon carbonitride (SiCN) and other insulating materials related to the integrated circuit.

The bottom insulating layer 17 and the sidewall insulating layer 18 may be insulating materials of the same material or insulating materials of different materials.

It should be noted that the forming process of the bottom insulating layer 17, the sidewall insulating layer 18, and the via portion 21 can be selected from a Physical Vapor Deposition (PVD) process, a Chemical Vapor Deposition (CVD) process, an Atomic Layer Deposition (ALD) process, an In-Situ Steam Generation (ISSG) process, and a Spin On Dielectric (SOD) process, etc., which will not be limited herein.

In one embodiment, the method for manufacturing the semiconductor structure may further include an operation of forming an insulating covering layer 151 that may be configured to cover a top end of the opening 14 on the base body, so that the air gap 11 may be formed in the base body.

In one embodiment, the opening 14 is configured to expose the top end of the via portion 21; that is, after the via portion 21 being thermally expanded, the conductive material of the via portion 21 can directly enter the air gap 11, thereby preventing the conductive material from squeezing the surrounding lattice of the via portion 21 or other adjacent conductive layers.

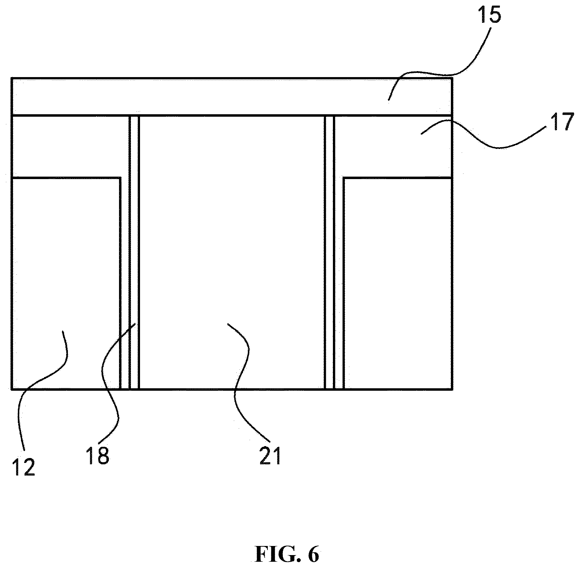

In one embodiment, as shown in FIG. 6, a first insulating layer 15 may be formed on the bottom insulating layer 17, and the first insulating layer 15 may be configured to cover the top end of the via portion 21.

In one embodiment, the operation of forming the opening 14 may include: forming a groove 16 on the first insulating layer 15, to expose part of the top end of the via portion 21; forming the first conductive layer 22 in the groove 16; forming a second insulating layer 19 that may be configured to cover the first conductive layer 22 on the first insulating layer 15; and forming the opening 14 on the second insulating layer 19 and the first insulating layer 15.

Specifically, the remaining part of the first insulating layer 15 may be surrounded by the groove 16, and the space occupied by the remaining part of the first insulating layer 15 may be the via 221 in the first conductive layer 22.

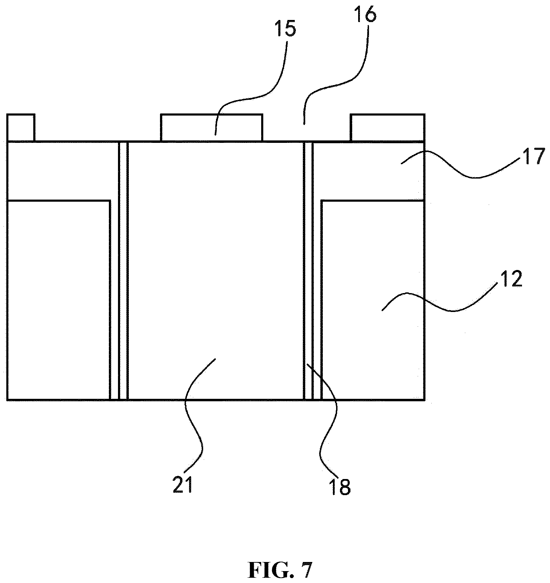

As shown in FIG. 7, on the basis of FIG. 6, the groove 16 may be formed in the first insulating layer 15, and the groove 16 may be an annular via, thereby exposing a part of the top end of the via portion 21.

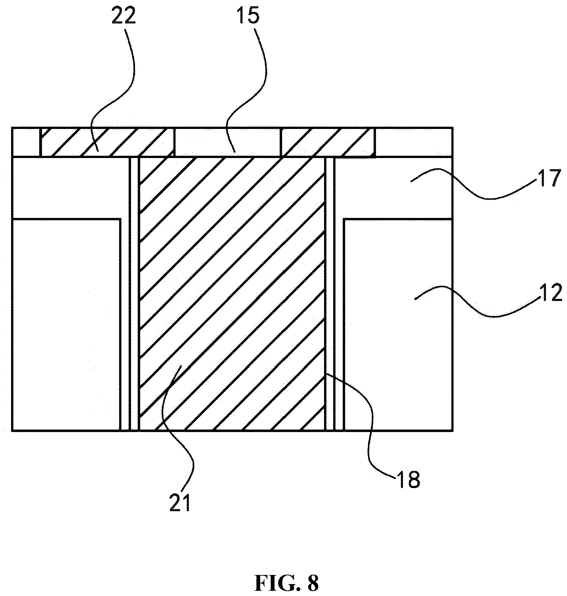

On the basis of FIG. 7, the conductive material may be filled in the groove 16 to form the first conductive layer 22 as shown in FIG. 8. At the time, the first conductive layer 22 may be connected with the via portion 21. The first conductive layer 22 may be provided with the first insulating layer 15 inside.

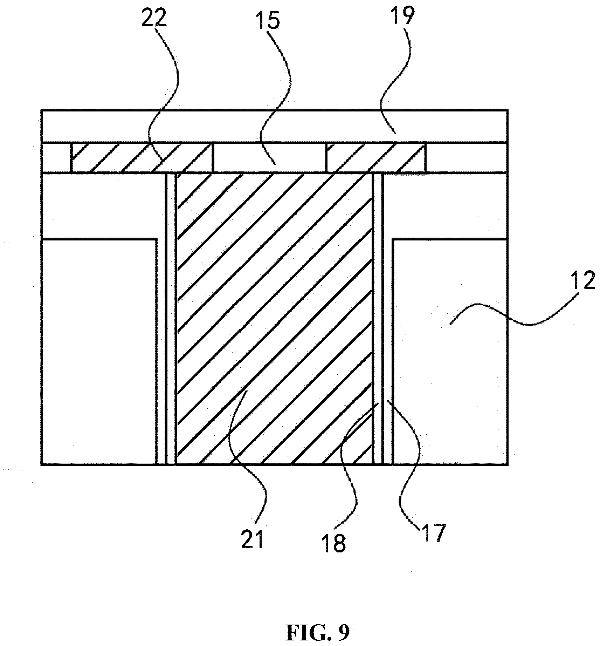

On the basis of FIG. 8, as shown in FIG. 9 in detail, the second insulating layer 19 may be covered on the first insulating layer 15 and the first conductive layer 22.

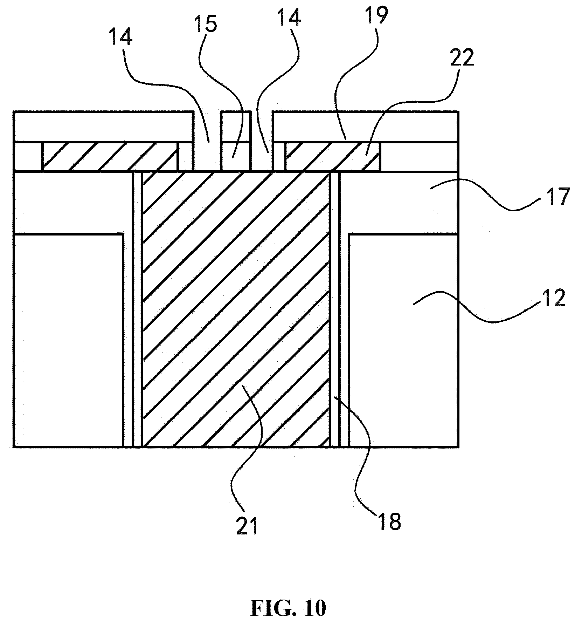

On the basis of FIG. 9, as shown in FIG. 10, the opening 14 may be formed in the second insulating layer 19 and the first insulating layer 15, and the opening 14 may also expose the top end of the via portion 21.

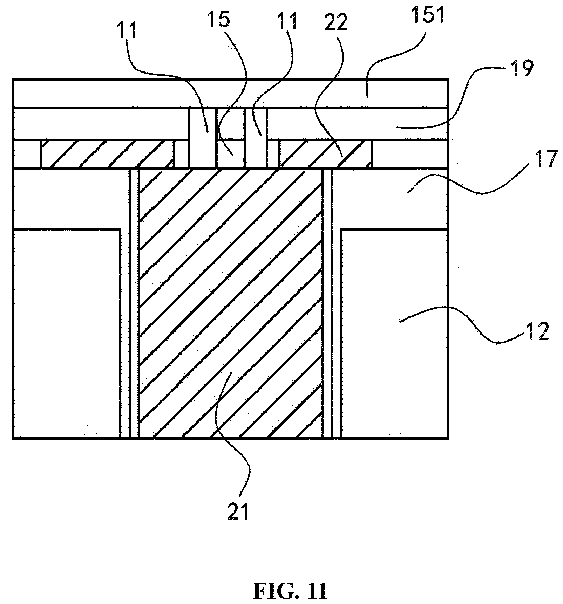

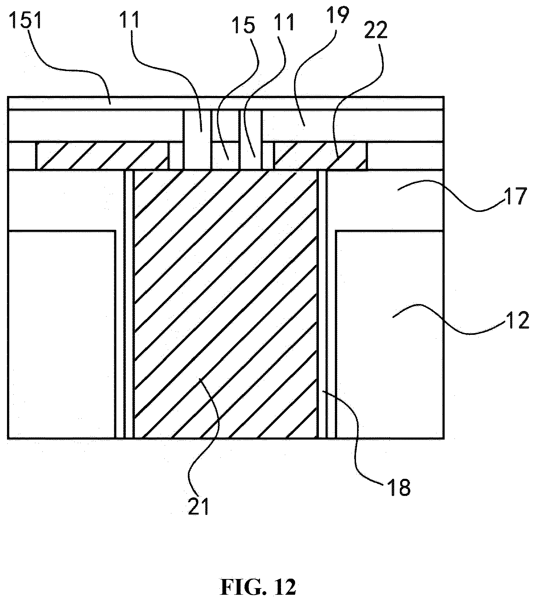

On the basis of FIG. 10, as shown in FIG. 11, a cover insulating layer 151 with a larger thickness may be formed on the second insulating layer 19, and then the insulating covering layer 151 may be thinned to form a structure as shown in FIG. 12.

It should be noted that the first insulating layer 15, the second insulating layer 19, and the insulating covering layer 151 may include silicon dioxide (SiO2), silicon oxycarbide (SiOC), silicon nitride (SiN), silicon carbonitride (SiCN) and other insulating materials related to the integrated circuit.

It should be noted that the forming process of the first insulating layer 15, the second insulating layer 19, and the insulating covering layer 151 can be selected from the Physical Vapor Deposition (PVD) process, the Chemical Vapor Deposition (CVD) process, the Atomic Layer Deposition (ALD) process, the In-Situ Steam Generation (ISSG) process, and the Spin On Dielectric (SOD) process, etc., which will not be limited herein.

The forming process of the opening 14 and the groove 16 may include a process of photolithography, a process of etching, etc. After each coating being formed, it can be treated in combination with a Chemical Mechanical Polishing (CMP) process to ensure the flatness of the coating. The first conductive layer 22 may be formed by a process of electroplating or sputtering, which will not be limited herein.

In one embodiment, the semiconductor structure may be formed by the aforementioned method for manufacturing the semiconductor structure. The method for manufacturing the semiconductor structure may further include the operation of forming the second conductive layer 30, etc., which will not be limited this time. The silicon substrate 12 and the aforementioned insulating layers may be all parts of the base 10. The bottom insulating layer 17, the sidewall insulating layer 18, the first insulating layer 15, the second insulating layer 19 and the insulating covering layer 151 may be all parts of the insulating layer 13.

After considering the specification and practicing the invention disclosed herein, those skilled in the art would easily conceive of other embodiments of the disclosure. The disclosure aims to cover various variation, usages or adaptive changes of the present invention, which follow the general principles of this disclosure and includes the common technical knowledge or commonly used technical means in the technical field not disclosed in this disclosure. The specification and exemplary embodiments are only considered exemplary, and the actual scope of the disclosure are pointed out by the appended claims.

## Claims

1. A semiconductor structure, comprising:
a base (10); and
a conductive portion (20), arranged in the base, and comprising a via portion (21) and a first conductive layer (22), where the first conductive layer (22) is connected with the via portion (21) and arranged above the via portion (21);
wherein an air gap (11) is arranged in the base (10), and one end of the air gap (11) is configured to expose the conductive portion (20);
wherein one end of the air gap (11) is configured to expose a top end of the via portion (21);
**characterized in that**,
a via (221) is arranged in the first conductive layer (22), to expose the top end of the via portion (21), and at least part of the air gap (11) is arranged in the via (221).

2. The semiconductor structure of claim 1, wherein the via (221) is arranged in a middle of the first conductive layer (22), an area of a cross section of the via (221) is smaller than an area of a cross section of the via portion (21), the via (221) is a circular hole, and a diameter of the via (221) is between 1 µm and 10 µm.

3. The semiconductor structure of claim 1, wherein a height of the air gap (11) is greater than a thickness of the first conductive layer (22), or equal to a height of the via (221), or greater than a height of the via (221).

4. The semiconductor structure of claim 1, wherein the air gap (11) is a circular hole, a diameter of the air gap (11) is between 20 nm and 200 nm, and a height of the air gap (11) is between 50 nm and 200 nm.

5. The semiconductor structure of claim 1 or 3, wherein the semiconductor structure further comprises:
a second conductive layer (30), arranged in the base (10), wherein the second conductive layer (30) is spaced apart from the first conductive layer (22), and arranged above the first conductive layer (22);
wherein the air gap (11) is arranged under the second conductive layer (30) and spaced apart from the second conductive layer (30).

6. The semiconductor structure of claim 1, wherein the air gap (11) comprises a plurality of air gaps (11) arranged at an interval, and each of the plurality of air gaps (11) is configured to expose the conductive portion (20).

7. The semiconductor structure according to claim 1, wherein the base (10) comprising:
a silicon substrate (12), wherein a top end of the silicon substrate (12) is higher than an upper surface of the silicon substrate (12); and
an insulating layer, configured to cover the upper surface of the silicon substrate (12) and cover an outer surface of the via portion (21);
wherein both of the first conductive layer (22) and the air gap (11) are arranged in the insulating layer.

8. The semiconductor structure of claim 1, wherein the via portion (21) is a silicon via.

9. A semiconductor structure, comprising:
a base (10); and
a conductive portion (20), arranged in the base, and comprising a via portion (21) and a first conductive layer (22), where the first conductive layer (22) is connected with the via portion (21) and arranged above the via portion (21);
wherein an air gap (11) is arranged in the base (10), and one end of the air gap (11) is configured to expose the conductive portion (20);
wherein one end of the air gap (11) is configured to expose a top end of the via portion (21);
**characterized in that**,
the first conductive layer (22) comprises a plurality of sub-conductive layers that are spaced apart from each other, and two adjacent sub-conductive layers from the plurality of the sub-conductive layers are configured to expose the top end of the via portion (21); and wherein at least part of the air gap (11) is arranged between the two adjacent sub-conductive layers.

10. A method for manufacturing a semiconductor structure, comprising:
providing (S101) a base body, wherein a conductive portion is formed in the base body, and the conductive portion comprises a via portion (21) and a first conductive layer (22), wherein the first conductive layer (22) is connected with the via portion (21) and arranged above the via portion (21); and
forming (S103) an opening (14) on the base body, wherein the opening (14) is configured to expose the conductive portion and serve as an air gap (11);
wherein the opening (14) is configured to expose a top end of the via portion (21);
**characterized in that**,
a via (221) is arranged in the first conductive layer (22), to expose the top end of the via portion (21), and at least part of the air gap (11) is arranged in the via (221).

11. The method for manufacturing the semiconductor structure of claim 10, further comprising:
forming an insulating covering layer (151), wherein the insulating covering layer (151) is configured to cover a top end of the opening (14) on the base body.

12. The method for manufacturing the semiconductor structure of claim 11, wherein the base body comprises a silicon substrate (12) and a first insulating layer (15), and wherein forming the opening (14) comprises:
forming a groove (16) on the first insulating layer (15), to expose part of the top end of the via portion (21);
forming the first conductive layer (22) in the groove (16);
forming a second insulating layer (19), wherein the second insulating layer (19) is configured to cover the first conductive layer (22) on the first insulating layer (15); and
forming the opening (14) on the second insulating layer (19) and the first insulating layer (15).

## Patentansprüche

1. Halbleiterstruktur, mit:
einer Basis (10); und
einem leitenden Abschnitt (20), der in der Basis angeordnet ist und einen Durchkontaktierungsabschnitt (21) und eine erste leitende Schicht (22) aufweist, wobei die erste leitende Schicht (22) mit dem Durchkontaktierungsabschnitt (21) verbunden und über dem Durchkontaktierungsabschnitt (21) angeordnet ist;
wobei ein Luftspalt (11) in der Basis (10) angeordnet ist und ein Ende des Luftspalts (11) so eingerichtet ist, dass er den leitenden Abschnitt (20) freilegt;
wobei ein Ende des Luftspalts (11) so eingerichtet ist, dass es ein oberes Ende des Durchkontaktierungsabschnitts (21) freilegt;
**dadurch gekennzeichnet, dass**,
eine Durchkontaktierung (221) in der ersten leitenden Schicht (22) angeordnet ist, um das obere Ende des Durchkontaktierungsabschnitts (21) freizulegen, und mindestens ein Teil des Luftspalts (11) in der Durchkontaktierung (221) angeordnet ist.

2. Halbleiterstruktur nach Anspruch 1, wobei die Durchkontaktierung (221) in der Mitte der ersten leitenden Schicht (22) angeordnet ist, eine Querschnittsfläche der Durchkontaktierung (221) kleiner ist als eine Querschnittsfläche des Durchkontaktierungsabschnitts (21), die Durchkontaktierung (221) ein kreisförmiges Loch ist und ein Durchmesser der Durchkontaktierung (221) zwischen 1 µm und 10 µm liegt.

3. Halbleiterstruktur nach Anspruch 1, wobei die Höhe des Luftspalts (11) größer als die Dicke der ersten leitenden Schicht (22) oder gleich der Höhe der Durchkontaktierung (221) oder größer als die Höhe der Durchkontaktierung (221) ist.

4. Halbleiterstruktur nach Anspruch 1, wobei der Luftspalt (11) ein kreisförmiges Loch ist, ein Durchmesser des Luftspalts (11) zwischen 20 nm und 200 nm liegt und eine Höhe des Luftspalts (11) zwischen 50 nm und 200 nm beträgt.

5. Halbleiterstruktur nach Anspruch 1 oder 3, wobei die Halbleiterstruktur ferner aufweist:
eine zweite leitende Schicht (30), die in der Basis (10) angeordnet ist, wobei die zweite leitende Schicht (30) von der ersten leitenden Schicht (22) beabstandet ist und über der ersten leitenden Schicht (22) angeordnet ist;
wobei der Luftspalt (11) unter der zweiten leitenden Schicht (30) und beabstandet von der zweiten leitenden Schicht (30) angeordnet ist.

6. Halbleiterstruktur nach Anspruch 1, wobei der Luftspalt (11) eine Vielzahl von Luftspalten (11) aufweist, die in einem Abstand angeordnet sind, und jeder der Vielzahl von Luftspalten (11) so eingerichtet ist, dass er den leitenden Abschnitt (20) freilegt.

7. Halbleiterstruktur nach Anspruch 1, wobei die Basis (10) aufweist:
ein Siliziumsubstrat (12), wobei ein oberes Ende des Siliziumsubstrats (12) höher ist als eine obere Oberfläche des Siliziumsubstrats (12); und
eine Isolierschicht, die so eingerichtet ist, dass sie die obere Oberfläche des Siliziumsubstrats (12) bedeckt und eine äußere Oberfläche des Durchkontaktierungsabschnitts (21) bedeckt;
wobei sowohl die erste leitende Schicht (22) als auch der Luftspalt (11) in der Isolierschicht angeordnet sind.

8. Halbleiterstruktur nach Anspruch 1, wobei der Durchkontaktierungsabschnitt (21) eine Siliziumdurchkontaktierung ist.

9. Halbleiterstruktur, mit:
einer Basis (10); und
einem leitenden Abschnitt (20), der in der Basis angeordnet ist und einen Durchkontaktierungsabschnitt (21) und eine erste leitende Schicht (22) aufweist, wobei die erste leitende Schicht (22) mit dem Durchkontaktierungsabschnitt (21) verbunden und über dem Durchkontaktierungsabschnitt (21) angeordnet ist;
wobei ein Luftspalt (11) in der Basis (10) angeordnet ist und ein Ende des Luftspalts (11) so eingerichtet ist, dass er den leitenden Abschnitt (20) freilegt;
wobei ein Ende des Luftspalts (11) so eingerichtet ist, dass es ein oberes Ende des Durchkontaktierungsabschnitts (21) freilegt;
**dadurch gekennzeichnet, dass**,
die erste leitende Schicht (22) eine Vielzahl von subleitenden Schichten aufweist, die voneinander beabstandet sind, und zwei benachbarte subleitende Schichten aus der Vielzahl der subleitenden Schichten so eingerichtet sind, dass sie das obere Ende des Durchkontaktierungsabschnitts (21) freilegen; und wobei mindestens ein Teil des Luftspalts (11) zwischen den zwei benachbarten subleitenden Schichten angeordnet ist.

10. Verfahren zur Herstellung einer Halbleiterstruktur, umfassend:
Bereitstellen (S101) eines Basiskörpers, wobei ein leitender Abschnitt in dem Basiskörper ausgebildet ist und der leitende Abschnitt einen Durchkontaktierungsabschnitt (21) und eine erste leitende Schicht (22) aufweist, wobei die erste leitende Schicht (22) mit dem Durchkontaktierungsabschnitt (21) verbunden und über dem Durchkontaktierungsabschnitt (21) angeordnet ist; und
Ausbilden (S103) einer Öffnung (14) auf dem Basiskörper, wobei die Öffnung (14) so eingerichtet ist, dass sie den leitenden Abschnitt freilegt und als Luftspalt (11) dient;
wobei die Öffnung (14) so eingerichtet ist, dass sie ein oberes Ende des Durchkontaktierungsabschnitts (21) freilegt;
**dadurch gekennzeichnet, dass**,
eine Durchkontaktierung (221) in der ersten leitenden Schicht (22) angeordnet ist, um das obere Ende des Durchkontaktierungsabschnitts (21) freizulegen, und mindestens ein Teil des Luftspalts (11) in der Durchkontaktierung (221) angeordnet ist.

11. Verfahren zur Herstellung der Halbleiterstruktur nach Anspruch 10, das ferner umfasst:
Ausbilden einer isolierenden Abdeckschicht (151), wobei die isolierende Abdeckschicht (151) so eingerichtet ist, dass sie ein oberes Ende der Öffnung (14) auf dem Basiskörper abdeckt.

12. Verfahren zur Herstellung der Halbleiterstruktur nach Anspruch 11, wobei der Basiskörper ein Siliziumsubstrat (12) und eine erste Isolierschicht (15) aufweist, und wobei das Ausbilden der Öffnung (14) umfasst:
Ausbilden einer Rille (16) auf der ersten Isolierschicht (15), um einen Teil des oberen Endes des Durchkontaktierungsabschnitts (21) freizulegen;
Ausbilden der ersten leitenden Schicht (22) in der Rille (16);
Ausbilden einer zweiten Isolierschicht (19), wobei die zweite Isolierschicht (19) so eingerichtet ist, dass sie die erste leitende Schicht (22) auf der ersten Isolierschicht (15) bedeckt; und
Ausbilden der Öffnung (14) auf der zweiten Isolierschicht (19) und der ersten Isolierschicht (15).

## Revendications

1. Structure semi-conductrice, comprenant :
une base (10) ; et
une partie conductrice (20), agencée dans la base, et comprenant une partie formant via (21) et une première couche conductrice (22), la première couche conductrice (22) étant connectée à la partie formant via (21) et disposée au-dessus. la partie formant via (21) ;
dans lequel un espace d'air (11) est disposé dans la base (10), et une extrémité de l'espace d'air (11) est configurée pour exposer la partie conductrice (20);
dans lequel une extrémité de l'espace d'air (11) est configurée pour exposer une extrémité supérieure de la partie formant via (21) ;
**caractérisé en ce qu'**un via (221) est disposé dans la première couche conductrice (22), pour exposer l'extrémité supérieure de la partie formant via (21), et au moins une partie de l'espace d'air (11) est disposée dans le via (221).

2. Structure semi-conductrice selon la revendication 1, dans laquelle le via (221) est disposé au milieu de la première couche conductrice (22), une aire d'une section transversale du via (221) est plus petite qu'une aire d'une section transversale de la partie formant via (21), le via (221) est un trou circulaire, et le diamètre du via (221) est compris entre 1µm et 10µm.

3. Structure semi-conductrice selon la revendication 1, dans laquelle une hauteur de l'espace d'air (11) est supérieure à une épaisseur de la première couche conductrice (22), ou égale à une hauteur du via (221), ou supérieure à une hauteur du via (221).

4. Structure semi-conductrice selon la revendication 1, dans laquelle l'espace d'air (11) est un trou circulaire, un diamètre de l'espace d'air (11) est compris entre 20 nm et 200 nm, et une hauteur de l'espace d'air (11) est comprise entre 50 nm et 200 nm.

5. Structure semi-conductrice selon la revendication 1 ou 3, dans laquelle la structure semi-conductrice comprend en outre :
une deuxième couche conductrice (30), disposée dans la base (10), la deuxième couche conductrice (30) étant espacée de la première couche conductrice (22), et disposée au-dessus de la première couche conductrice (22) ;
dans lequel l'espace d'air (11) est disposé sous la deuxième couche conductrice (30) et espacé de la deuxième couche conductrice (30).

6. Structure semi-conductrice selon la revendication 1, dans laquelle l'espace d'air (11) comprend une pluralité d'espaces d'air (11) disposés à un intervalle, et chacun de la pluralité d'espaces d'air (11) est configuré pour exposer la partie conductrice (20).

7. Structure semiconductrice selon la revendication 1, dans laquelle la base (10) comprenant :
un substrat de silicium (12), dans lequel une extrémité supérieure du substrat de silicium (12) est plus haute qu'une surface supérieure du substrat de silicium (12) ; et
une couche isolante, configurée pour recouvrir la surface supérieure du substrat de silicium (12) et recouvrir une surface externe de la partie formant via (21) ;
dans lequel la première couche conductrice (22) et l'espace d'air (11) sont disposés dans la couche isolante.

8. Structure semi-conductrice selon la revendication 1, dans laquelle la partie formant via (21) est un via en silicium.

9. Structure semi-conductrice, comprenant :
une base (10) ; et
une partie conductrice (20), agencée dans la base, et comprenant une partie formant via (21) et une première couche conductrice (22), la première couche conductrice (22) étant connectée à la partie formant via (21) et disposée au-dessus de la partie formant via (21) ;
dans lequel un espace d'air (11) est disposé dans la base (10), et une extrémité de l'espace d'air (11) est configurée pour exposer la partie conductrice (20) ;
dans lequel une extrémité de l'espace d'air (11) est configurée pour exposer une extrémité supérieure de la partie formant via (21);
**caractérisé en ce que**
la première couche conductrice (22) comprend une pluralité de sous-couches conductrices qui sont espacées les unes des autres, et deux sous-couches conductrices adjacentes parmi la pluralité des sous-couches conductrices sont configurées pour exposer l'extrémité supérieure de la partie formant via (21) ; et
dans lequel au moins une partie de l'espace d'air (11) est disposée entre les deux sous-couches conductrices adjacentes.

10. Procédé de fabrication d'une structure semiconductrice, comprenant les étapes consistant à :
fournir (S 101) un corps de base, une partie conductrice étant formée dans le corps de base, et la partie conductrice comprenant une partie formant via (21) et une première couche conductrice (22), la première couche conductrice (22) étant connectée avec la partie formant via (21) et disposé au-dessus de la partie formant via (21) ; et
former (S 103) une ouverture (14) sur le corps de base, l'ouverture (14) étant configurée pour exposer la partie conductrice et servir d'espace d'air (11) ;
dans lequel l'ouverture (14) est configurée pour exposer une extrémité supérieure de la partie formant via (21) ;
**caractérisé en ce qu'**un via (221) est disposé dans la première couche conductrice (22), pour exposer l'extrémité supérieure de la partie formant via (21), et au moins une partie de l'espace d'air (111) est disposée dans le via (221).

11. Procédé de fabrication de la structure semi-conductrice selon la revendication 10, comprenant en outre l'étape consistant à :
former une couche de revêtement isolante (151), la couche de revêtement isolante (151) étant configurée pour recouvrir une extrémité supérieure de l'ouverture (14) sur le corps de base.

12. Procédé de fabrication de la structure semi-conductrice selon la revendication 11, dans lequel le corps de base comprend un substrat de silicium (12) et une première couche isolante (15), et dans lequel la formation de l'ouverture (14) comprend les étapes consistant à :
former une rainure (16) sur la première couche isolante (15), pour exposer une partie de l'extrémité supérieure de la partie formant via (21) ;
former la première couche conductrice (22) dans la rainure (16) ;
former une deuxième couche isolante (19), la deuxième couche isolante (19) étant configurée pour recouvrir la première couche conductrice (22) sur la première couche isolante (15) ; et
former l'ouverture (14) sur la deuxième couche isolante (19) et la première couche isolante (15).
